## Europäisches Patentamt

## European Patent Office

## Office européen des brevets

(11) Veröffentlichungsnummer: **0 209 727**
**B1**

(12)

# EUROPÄISCHE PATENTSCHRIFT

(45) Veröffentlichungstag der Patentschrift:
08.11.89

(51) Int. Cl.⁴: **G01R 21/01**

(21) Anmeldenummer: 86108332.7

(22) Anmeldetag: 19.06.86

(54) **Verfahren und Spektrometer zum Bestimmen der Mikrowellenleistung in einem Überdimensionierten Mikrowellen-Hohlleiter.**

(30) Priorität: 19.07.85 DE 3525918

(43) Veröffentlichungstag der Anmeldung:
28.01.87 Patentblatt 87/5

(45) Bekanntmachung des Hinweises auf die Patenterteilung:
08.11.89 Patentblatt 89/45

(84) Benannte Vertragsstaaten:
CH DE FR GB IT LI NL

(56) Entgegenhaltungen:
US-A- 2 479 650
US-A- 3 327 211

(73) Patentinhaber: Max-Planck-Gesellschaft zur Förderung der Wissenschaften e.V., Bunsenstrasse 10, D-3400 Göttingen(DE)

(72) Erfinder: Kasparek, Walter, Dr., Waldburgstrasse 49, D-7000 Stuttgart 80(DE)
Erfinder: Müller, Günter, Dr., Strutweg 4, D-7062 Rudersberg(DE)

(74) Vertreter: Heusler, Wolfgang, Dipl.-Ing. et al, Dr. Dieter von Bezold Dipl.-Ing. Peter Schütz Dipl.-Ing. Wolfgang Heusler Brienner Strasse 52, D-8000 München 2(DE)

ACTORUM AG

## Beschreibung

Die Erfindung betrifft ein Verfahren zum Bestimmen der Mikrowellenleistung im Spektrum der in einem überdimensionierten Mikrowellen-Hohlleiter hin- und/oder rücklaufenden Wellenmoden gemäß dem Oberbegriff des Anspruchs 1 sowie ein zum Durchführen dieses Verfahrens verwendbares Spektrometer.

Wenn die Breite von Rechteckhohlleitern bzw. der Durchmesser von Rundhohlleitern wesentlich größer ist als die Vakuumwellenlänge der transportierten Mikrowellen, handelt es sich um überdimensionierte Hohlleiter, in denen sich bekanntlich neben der Hauptmode u.a. infolge geometrischer Unvollkommenheiten des Hohlleiters ein Spektrum mehrerer weiterer Moden (Wellentypen) mit unterschiedlichen axialen Wellenzahlen ausbreiten kann. Insbesondere zum Transport von hohen Leistungen bei hohen Frequenzen müssen zur Vermeidung von Durchschlägen stark überdimensionierte Hohlleiter verwendet werden. Beispielsweise wird zur Erhitzung eines Plasmas durch ein Gyrotron, das eine Leistung von 200 kW bei 70 GHz erzeugt, ein Rundhohlleiter mit einem Durchmesser von 28 mm verwendet, in dem bereits 110 verschiedene Wellentypen auftreten können. Die einzelnen Moden haben in der Regel unterschiedliche Leistungen, und häufig ist es erforderlich, für die verschiedenen Moden jeweils deren Leistung zu ermitteln. Zu diesem Zweck ist es bekannt, an der Hohlleiterwand modenselektive Richtkoppler mit einer Vielzahl axial verteilter Löcher anzuordnen ("Int. J. of Infrared and Millim. Waves" Vol. 5 (1984), Seiten 887-918 und 1405-1417). Die Koppel lochverteilung und die Abmessungen des Koppelhohlleiters am Richtkoppler erfordern ein höchstes Maß an mechanischer Präzision, wenn die Einkopplung eines erheblichen Störspektrums in den Richtkoppler vermieden werden soll. Vor allem ist für jede zu messende Hohlleitermode ein gesonderter Richtkoppler, d.h. eine weitere Koppellochstruktur, erforderlich.

Der Erfindung liegt die Aufgabe zugrunde, ein Verfahren bzw. ein Spektrometer anzugeben, die die Bestimmung der Leistung des Modenspektrums bei gewünschter Modenselektivität mit geringerem mechanischen Aufwand als bisher und insbesondere ohne die Notwendigkeit mehrerer Koppelstrukturen (Richtkoppler) ermöglichen.

Diese Aufgabe wird durch die Merkmale der Ansprüche 1 bzw. 4 gelöst.

Durch die Erfindung ist es möglich, mit nur einer Koppelstruktur, an deren mechanische Präzision keine besonders hohen Anforderungen gestellt werden, das gesamte Spektrum der hin- und rücklaufenden Hohlleitermoden zu messen. Vorteilhaft ist auch, daß hin- und rücklaufende Wellen im Meßsystem nicht interferieren. Außerdem ist bei der Erfindung die Leistungsmessung nicht wie bisher auf ein "monochromatisches" System mit nur einer Sendefrequenz beschränkt, sondern sie kann auch bei Hohlleitern durchgeführt werden, in denen ein Frequenzgemisch herrscht, wenn man frequenzselektive Empfangseinrichtungen verwendet oder das Antennensignal frequenzselektiv auswertet.

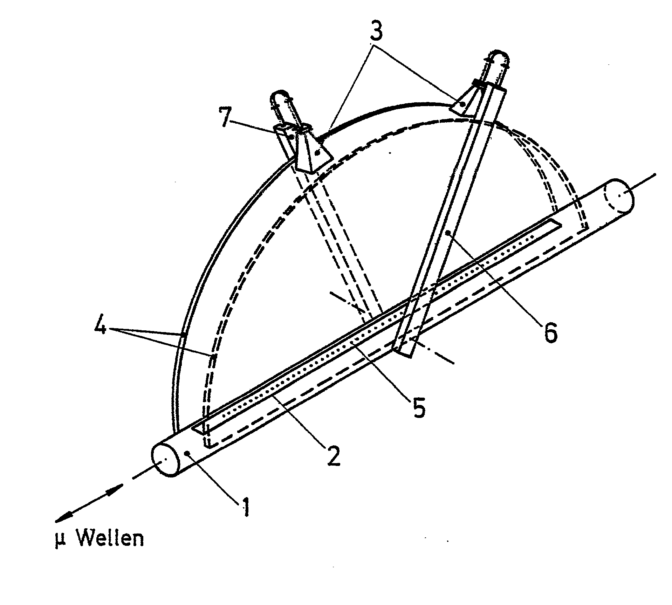

Die Erfindung macht sich die Erkenntnis zunutze, daß die Leistung jeder Mode an der Auskoppelstruktur unter einem eigenen Winkel abgestrahlt wird und man von dem jeweiligen Winkel auf die zugehörige Mode schließen kann, wie im folgenden anhand eines Ausführungsbeispiels eines geeigneten Wellenzahl-Spektrometers erläutert wird. Das Spektrometer ist vereinfacht und schematisch in der Zeichnung dargestellt.

Die Mikrowellen, deren spektrale Leistungsverteilung modenselektiv gemessen werden soll, durchlaufen in einer oder beiden Richtungen einen Hohlleiter 1, der stark überdimensioniert im eingangs erläuterten Sinn sein kann, also in der Regel ein Spektrum vieler Moden unterschiedlicher axialer Wellenzahlen ($\beta = 2\pi$/Wellenlänge $\lambda$ der Mode im Hohlleiter) führt, die durch das hier beschriebene Spektrometer ermittelt werden können.

Parallel zur Wellenlaufrichtung erstreckt sich in der Wand des Hohlleiters 1 eine Auskoppelstruktur 2 mit einer axialen Reihe von Löchern 5 unterschiedlichen Durchmessers, deren Mittenabstände untereinander gleich sein können und höchstens etwa gleich der halben Vakuumwellenlänge sind, also in jedem Fall kleiner als die halbe Wellenlänge der Hohlleitermode mit der geringsten Phasengeschwindigkeit. Die Durchmesser der Löcher, die von der Mitte der Auskoppelstruktur 2 aus zu deren Enden hin beispielsweise im Verhältnis 2:1 abnehmen, und damit die axiale Verteilung der Lochkopplung sind so gewählt, daß sich näherungsweise eine Gaußförmige Mikrowellentransparenz des Hohlleiters in axialer Richtung ergibt. Die Länge der Loch- bzw. Auskoppelstruktur bestimmt im wesentlichen die Auflösung des Spektrometers. Sollen zwei Hohlleitermoden mit den Wellenlängen $\lambda_1$, $\lambda_2$ voneinander getrennt werden, so muß die Länge mindestens gleich der Schwebungswellenlänge beider Moden sein, d.h. die minimale Länge der Struktur ist

$$1_{min} = \lambda_1 \cdot \lambda_2 |\lambda_1 - \lambda_2|.$$

Bei dem eingangs erwähnten Beispiel eines Rundhohlleiters zur Erhitzung eines Plasmas mit einem Durchmesser von etwa 28 mm (die Querschnittsform des Hohlleiters 1 ist für das beschriebene Verfahren an sich beliebig) kann die Auskoppelstruktur zur Identifikation der wichtigsten Moden beispielsweise 400 mm lang sein. Statt offener Löcher kann es auch zweckmäßig sein, alle oder einige der Öffnungen mit einem die ausgekoppelte Leistung dämpfenden Dielektrikum auszufüllen, was den Vorteil haben kann, daß man für eine gewünschte Mikrowellentransparenz mit weniger dünnen Löchern in der Hohlleiterwand auskommt, die einfacher herstellbar sind. Entsprechendes gilt für einen die Auskoppelstruktur ggf. bildenden Längsschlitz im Hohlleiter.

An der Mitte der Auskoppelstruktur 2 sind auf einer senkrecht zur Abstrahlungsebene, also quer zum Hohlleiter 1 liegenden Achse zwei Arme 6 bzw. 7 schwenkbar gelagert, die sich auf den beiden Seiten des Hohlleiters 1 in Abstrahlungsrichtung erstrecken. Am freien Ende dieser Arme ist jeweils eine richtungsselektive Empfangsantenne 3 wie z.B. eine Horn- oder Linsenantenne so montiert, daß sie der Mitte der Auskoppelstruktur 2 zugewandt ist. Die richtungsselektiven Empfangsantennen 3 befinden sich im Nahfeld der Auskoppelstruktur 2, worunter ein von der wirksamen Länge 1 der Auskoppelstruktur 2 abhängiger Bereich zu verstehen ist, der sich vom Zentrum der Auskoppelstruktur bis zu einer Entfernung von

$(1 \cdot \sin\alpha)^2/\lambda_0$

erstreckt, wobei $\alpha$ der jeweilige Winkel zwischen der Abstrahlungsrichtung und der Hohlleiterlängsachse und $\lambda_0$ die Vakuumwellenlänge bedeuten.

Je nach Anwendungsfall und insbesondere bei Auskopplung eines starken Strahlungsfeldes kann man die Empfangsantenne auch in dem jenseits des erwähnten Nahfeldes liegenden Fernbereich, also in größerer Entfernung von der Auskoppelstruktur 2, anordnen. In diesem Fall genügt eine einfache, d.h. nicht-richtungsselektive Empfangsantenne zur Intensitätsmessung, da im Fernbereich die einzelnen Strahlungen in ausreichendem Maße voneinander getrennt sind.

Zur Abschirmung der Strahlung nach außen und zur Vermeidung parasitärer Einstreuungen wird der Abstrahlungsraum zwischen der Auskoppelstruktur 2 und den Antennen 3 durch seitliche, zur Abstrahlungsebene parallele Wände 4 aus absorbierendem Material begrenzt.

Alternativ hierzu können die ausgekoppelten Wellen vor ihrer Abstrahlung zwischen Metallplatten oder in einer dielektrischen Schicht geführt werden. Damit kann die Intensität des Strahlungsfeldes an der Empfangsantenne erhöht werden.

Im Betrieb des Spektrometers wird beispielsweise der Arm 6 mit der Empfangsantenne 3 kontinuierlich über seinen gesamten Winkelbereich von 0 bis 180° bezüglich der Hohlleiterachse geschwenkt und hierbei die jeweils gemessene Leistung unter Zuordnung zu den einzelnen Winkeln registriert. Dies kann im einfachsten Fall durch Verschwenken des Armes von Hand und gleichzeitiges Aufzeichnen der gemessenen Leistung in einer Tabelle oder Kurve erfolgen. Vorzugsweise wird die Antenne 3 aber von einer mit einem Motor verbundenen Antriebseinrichtung (nicht dargestellt) verstellt, die mit der an die Antenne 3 angeschlossenen Leistungsmeßeinrichtung synchronisiert, d.h. über ein Rückmeldesystem z.B. mit einem automatischen Schreiber oder Rechner gekoppelt ist.

Die dargestellte zweite Empfangsantenne 3 an dem Arm 7 ist für die Messung nicht unbedingt notwendig. Sie kann aber an einer ausgewählten Winkelposition feststehend zur Erzeugung eines Referenzsignals während der Messung dienen.

Eine andere Möglichkeit ist das gleichzeitige Messen von zwei Moden mit den beiden Empfangsantennen. Schließlich besteht auch die Möglichkeit, mit der einen Antenne die Leistung jeder Mode in Hinlaufrichtung und mit der anderen Antenne diejenige in Rücklaufrichtung zu messen.

Auch bei Verwendung von nur einer Empfangsantenne erfolgt die Unterscheidung der im Hohlleiter 1 hin- und rücklaufenden Wellen über die Auskoppelrichtung. Der für die jeweilige Mode charakteristische Auskoppelwinkel $\alpha$ wird bezüglich der Ausbreitungsrichtung im Hohlleiter gemessen und ist (für Lochabstände kleiner als $\lambda/2$) immer kleiner als 90°. Folglich werden vorwärtslaufenden Wellen nach vorwärts, rücklaufenden Wellen dagegen nach rückwärts ausgekoppelt.

Zur Messung des gesamten Spektrums mit nur einer Koppelstruktur muß diese sowohl TE-Moden als auch TM-Moden auskoppeln. Je nach Wahl der Öffnungen (Schlitze bzw. Löcher) und der Polarisation der Empfangsantenne kann jedoch das Spektrum der TE- bzw. TM-Moden bevorzugt oder unterdrückt werden. Auskopplungsschlitze statt der dargestellten Löcher bevorzugen die Wellen mit Wandströmen quer zur Schlitzrichtung. Es kann auch notwendig sein, eine von zwei bestimmten Moden zu unterdrücken, die im Hohlleiter die gleiche Phasengeschwindigkeit haben und deshalb unter dem selben Winkel ausgekoppelt würden (z.B. TE 01 und TM 11). In diesem Fall könnten die Moden nur über die Polarisation der Strahlung getrennt werden.

Durch die erwähnte Gaußförmige oder sonstige inhomogene axiale Transparenz der Koppelstruktur lassen sich bereits im Nahfeld nahezu ebene Phasenflächen in der Hauptstrahlrichtung und geringe Nebenzipfel bei Abstrahlung unter anderem Winkel erzielen. Die Erfindung ist aber nicht auf eine bestimmte Transparenz beschränkt. Statt der Gaußförmigen kann man beispielsweise auch eine cosinus- oder rechteckförmigen Abstrahlcharakteristik wählen, wie dies an sich aus der Sendeantennentechnik (z.B. Leaky-Wave-Antennen) bekannt ist. Die Messung wird aber schwieriger, wenn die Nebenmaxima der Abstrahlcharakteristik nicht ausreichend tief unter dem Hauptmaximum liegen.

Bei dem hier beschriebenen Verfahren werden die ausgekoppelten Wellen nicht wie bisher in einen Koppelhohlleiter, sondern in den ggf. durch die Abschirmungswände 4 begrenzten Freiraum außerhalb des Hohlleiters 1 abgestrahlt. Aus jedem der Löcher 5, bei denen es sich im Prinzip um einen kleinen, stark dämpfenden Hohlleiter mit einer der Öffnungstiefe entsprechenden Länge handelt, kommt eine kleine Elementarwelle mit einer bestimmten Phasenbeziehung entsprechend der Wellenlänge im Hohlleiter. Durch konstruktive Interferenz bildet sich eine Wellenfront aus, die unter bestimmten Winkeln $\alpha$ vom Hohlleiter ausgeht, die nach der Beziehung

$$\alpha = \text{arc cos} \frac{c \cdot \beta_h}{\omega \cdot n}$$

in der c die Lichtgeschwindigkeit, n den Brechungsindex des Mediums (Luft) in der Umgebung des Hohlleiters 1 und $\omega$ die im Hohlleiter 1 herrschende Kreisfrequenz bedeuten, mit der der Wellenzahl $\beta = 2\pi/\lambda$ entsprechenden Ausbreitungskonstante $\beta_h$ und damit mit den einzelnen Moden verknüpft sind. Mit anderen Worten, läßt sich aus dem gemessenen Winkel $\alpha$ über die obige Gleichung bei bekannten Hohlleiterabmessungen die jeweilige Mode identifizieren. Im Rechteckhohlleiter mit den Querabmessungen a, b ergeben sich (als Lösungen der Wellengleichung) Wellen mit sinus- und cosinusförmigen Feldverteilungen und einer Ausbreitungskonstante $\beta_h = 2\pi/\Lambda$, wobei $\Lambda$ die Hohlleiterwellenlänge ist.

Bekanntlich (vgl. Meyer/Pottel, "Physikal. Grundl. d. Hochfrequenz", Verlag Veweg, 1969, S. 153-177) ergibt sich:

$$\beta_h = \sqrt{\left(\frac{2\pi}{\lambda_o}\right)^2 - \left(\frac{m\pi}{a}\right)^2 - \left(\frac{n\pi}{b}\right)^2}$$

$$= \frac{2\pi}{\lambda_o}\sqrt{1 - \left(\frac{m\lambda_o}{2a}\right)^2 - \left(\frac{n\lambda_o}{2b}\right)^2}$$

mit n, m=ganze Zahlen und $\lambda_o$= Vakuumwellenlänge. Für die Hohlleiterwellenlänge gilt entsprechend

$$\Lambda = \frac{\lambda_o}{\sqrt{1 - \left(\frac{m\lambda_o}{2a}\right)^2 - \left(\frac{n\lambda_o}{2b}\right)^2}}$$

Im Falle des Rundhohlleiters mit dem Radius a wird die radiale Feldverteilung durch Besselfunktionen erster Art der Ordnung m = 0, 1, 2 ... und deren Ableitungen ($J_m$ bzw. $\dot{J}_m$), die azimutale Verteilung durch Sinus- und Cosinusfunktionen beschrieben. Als Ausbreitungskonstante ergibt sich im Falle von $TM_{mn}$-Moden

$$\beta_h = \frac{2\pi}{\lambda_o} \cdot \sqrt{1 - \left(\frac{\lambda_o \nu_{mn}}{2\pi a}\right)^2}$$

mit $J_m(\nu_{mn}) = 0$, d.h. $\nu_{mn}$ ist das Argument der Besselfunktion m-ter Ordnung bei ihrer n-ten Nullstelle.

Für $TE_{mn}$ - Moden gilt

$$\beta_h = \frac{2\pi}{\lambda_o}\sqrt{1 - \left(\frac{\lambda_o \nu'_{mn}}{2\pi a}\right)^2}$$

mit $J_m(\nu'_{mn}) = 0$. Konstruktive Interferenz aller aus den verschiedenen Löchern 5 der Auskoppelstruktur 2 ausgekoppelten Teilwellen ergibt sich dann und nur dann, wenn

$$\cos \alpha = \frac{\lambda_o}{\Lambda} = \frac{\lambda_o \cdot \beta_h}{2\pi} = \frac{c}{\omega} \cdot \beta_h$$

Voraussetzung ist ein Lochabstand kleiner als $\lambda_o/2$. Befindet sich außerhalb des Hohlleiters ein Medium mit dem Brechungsindex n, so folgt für den Auskoppelwinkel $\alpha$ die oben angegebene Beziehung zwischen $\alpha$ und $\beta_h$.

## Patentansprüche

1. Verfahren zum Bestimmen der Mikrowellenleistung im Spektrum der in einem überdimensionierten Mikrowellen-Hohlleiter hin- und/oder rücklaufenden Wellenmoden, wobei ein Teil der Leistung jeder interessierten Mode durch eine parallel zur Hohlleiterlängsachse liegende Wand des Hohlleiters ausgekoppelt und gemessen wird, dadurch gekennzeichnet, daß die Winkelverteilung der abgestrahlten Mikrowellenleistung bezüglich der Hohlleiterlängsachse in Strahlungsfeld an der Auskopplungsstelle gemessen und aus der Winkelverteilung das Spektrum der interessierenden Wellenmoden ermittelt wird.

2. Verfahren nach Anspruch 1, dadurch gekennzeichnet, daß aus dem jeweiligen Winkel α zwischen der Strahlungsrichtung und der Hohlleiterlängsachse die der axialen Wellenzahl der jeweils gemessenen Mode im Hohlleiter entsprechende Ausbreitungskonstante $\beta_h$ nach der Beziehung

$$\alpha = \text{arc cos } \frac{c \cdot \beta_h}{\omega \cdot n}$$

bestimmt wird, wobei c die Lichtgeschwindigkeit, n der Brechungsindex des außerhalb des Hohlleiters befindlichen Mediums und ω die im Hohlleiter herrschende Kreisfrequenz sind.

3. Verfahren nach Anspruch 1 oder 2, dadurch gekennzeichnet, daß die Leistung der Moden jeweils im Bereich der Winkel α von weniger als 90° zwischen der jeweiligen Laufrichtung und der Abstrahlungsrichtung gemessen wird.

4. Spektrometer zum Durchführen des Verfahrens nach Anspruch 1, mit einer durch parallel zur Hohlleiterlängsachse verteilte Löcher (5) oder einen oder mehrere Längsschlitze in der Wand eines überdimensionierten Mikrowellen-Hohlleiters (1) gebildeten Auskoppelstruktur (2) und mit einer Einrichtung zum Messen der ausgekoppelten Leistung, dadurch gekennzeichnet, daß in einem Abstand von der Auskoppelstruktur (2) mindestens eine Empfangsantenne (3) angeordnet ist, deren Position auf unterschiedliche Winkel α im Strahlungsfeld an der Auskoppelstruktur (2) bezüglich der Hohlleiterlängsachse einstellbar ist, und daß aus der Winkelverteilung das Spektrum der interessierenden Wellenmoden ermittelbar ist.

5. Spektrometer nach Anspruch 4, dadurch gekennzeichnet, daß die Empfangsantenne (3) um eine an der Auskoppelstruktur (2) senkrecht zur Hohlleiterlängsachse liegende Achse schwenkbar ist.

6. Spektrometer nach Anspruch 5, dadurch gekennzeichnet, daß die Empfangsantenne (3) an einem an dem Hohlleiter (1) schwenkbar gelagerten Arm (6) montiert ist.

7. Spektrometer nach einem der Ansprüche 4 bis 6, dadurch gekennzeichnet, daß mindestens eine richtungsselektive Empfangsantenne (3) im Nahfeld der Auskoppelstruktur (2) angeordnet ist.

8. Spektrometer nach einem der Ansprüche 4 bis 6, dadurch gekennzeichnet, daß mindestens eine selektive oder nicht-richtungsselektive Antenne im Fernfeld der Auskoppelstruktur (2) angeordnet ist.

9. Spektrometer nach einem der Ansprüche 4 bis 8, dadurch gekennzeichnet, daß die Antenne (3) um die Mitte einer Auskoppelstruktur (2) in Form einer axialen Reihe von Löchern (5) schwenkbar ist, deren gegenseitiger Mittenabstand kleiner als die halbe Wellenlänge der Hohlleitermode mit der geringsten Phasengeschwindigkeit ist, während der Durchmesser der Löcher (5) von der Mitte der Auskoppelstruktur (2) aus zu den beiden Enden hin gemäß einer annähernd gaußförmigen axialen Mikrowellentransparenz kleiner wird.

10. Spektrometer nach einem der Ansprüche 4 bis 9, dadurch gekennzeichnet, daß der Abstrahlungsraum zwischen der Auskoppelstruktur (2) und der Antenne (3) durch seitliche, zum Strahlungsfeld parallele Abschirmungswände (4) aus absorbierendem Material begrenzt ist.

11. Spektrometer nach einem der Ansprüche 4 bis 9, dadurch gekennzeichnet, daß die Wellen vor ihrer Abstrahlung zwischen Metallplatten oder in einer dielektrischen Schicht geführt sind.

12. Spektrometer nach einem der Ansprüche 4 bis 11, dadurch gekennzeichnet, daß die axial verteilten Löcher oder ein die Auskoppelstruktur bildender Längsschlitz in der Wand des Hohlleiters (1) wenigstens teilweise mit einem Dielektrikum ausgefüllt sind.

13. Spektrometer nach einem der Ansprüche 4 bis 12, dadurch gekennzeichnet, daß zwei unabhängig voneinander verstellbare Antennen (3) vorgesehen sind.

14. Spektrometer nach einem der Ansprüche 4 bis 13, dadurch gekennzeichnet, daß die Antenne (3) von einer mit einem Motor verbundenen Antriebsrichtung verstellbar ist, die mit der an die Antenne (3) angeschlossenen Leistungsmeßeinrichtung synchronisiert ist.

## Claims

1. A method of determining the microwave power in the spectrum of the outgoing and/or returning wave modes in an overdimensioned microwave guide, a part of the power of each mode of interest being coupled out an measured by a waveguide wall situated parallel to the waveguide longitudinal axis, characterised in that the angular distribution of the radiated microwave power is measured relative to the waveguide longitudinal axis in the radiation field at the coupling-out place, and the spectrum of the wave modes of interest is determined from the angular distribution.

2. A method according to claim 1, characterised in that the propagation constand $\beta_h$ corresponding to the axis wave number of the respective measured mode in the waveguide is detemined from the respective angle $\alpha$ between the direction of radiation and the waveguide longitudinal axis in accordance with the relation

$$\alpha = \text{arc cos } \frac{c \cdot \beta_h}{\omega \cdot n}$$

where c is the speed of light, n is the refractive index of the medium outside the waveguide, and $\omega$ is the angular frequency in the waveguide.

3. A method according to claim 1 or 2, characterised in that the power of each mode is measured in the range below 90° of the angle $\alpha$ between the respective direction of motion and the direction of radiation.

4. A spectrometer for working the method according to claim 1, comprising a coupling-out structure (2) formed by holes (5) distributed parallel to the waveguide longitudinal axis or by one or more longitudinal slots in the wall of an overdimensioned microwave guide and a device for measuring the coupled-out power, characterised in that at least one receiving antenna (3) is disposed at a distance from the coupling-out structure (2) and its position is adjustable to various angles $\alpha$ in the radiation field on the coupling-out structure (2) relative to the waveguide longitudinal axis, and the spectrum of the wave modes of interest can be calculated from the angular distribution.

5. A spectrometer according to claim 4, characterised in that the receiving antenna (3) is pivotable around an axis on the coupling-out structure (2) perpendicular to the waveguide longitudinal axis.

6. A spectrometer according to claim 5, characterised in that the receiving antenna (3) is mounted on an arm (6) pivotable on the waveguide (1).

7. A spectrometer according to any of claims 4 to 6, characterised in that at least one directionally sensitive receiving antenna (3) is disposed in the near field of the coupling-out structure (2).

8. A spectrometer according to any of claims 4 to 6, characterised in that at least one selective or non-directionally selective antenna is disposed in the distant field of the coupling-out structure (2).

9. A spectrometer according to any of claims 4 to 8, characterised in that the antenna (3) is pivotable around the middle of a coupling-out structure (2) in the form of an axial row of holes (5), the average distance between the centres thereof being smaller and half the wavelength of the waveguide mode having the lowest phase speed, whereas the diameter of the holes (5) decreases from the centre of the coupling-out structure (2) towards the two ends in accordance with an approximately Gaussian axial microwave transparency.

10. A spectrometer according to any of claims 4 to 9, characterised in that the radiation space between the coupling-out structure (2) and the antenna (3) is bounded by lateral screening walls (4) of absorbent material parallel to the radiation field.

11. A spectrometer according to any of claims 4 to 9, characterised in that before being radiated, the waves are guided between metal plates or in a dielectric layer.

12. A spectrometer according to any of claims 4 to 11, characterised in that the axially distributed holes or a longitudinal slot in the waveguide wall and constituting the coupling-out structure are at least partly filled with a dielectric.

13. A spectrometer according to any of claims 4 to 12, characterised in that two independently adjustable antennas (3) are provided.

14. A spectrometer according to any of claims 4 to 13, characterised in that the antenna (3) is adjustable by a drive device connected to a motor and synchronized with the power-measuring device connected to the antenna (3).

## Revendications

1. Procédé de détermination de la puissance de microondes dans le spectre des modes d'ondes se propageant en avançant et/ou en reculant dans un guide micro d'ondes surdimensionné, une partie de la puissance de chaque mode intéressant étant découplé à travers une paroi du guide d'ondes s'étendant parallèlement à l'axe longitudinal du guide d'ondes et étant mesurée, caractérisé en ce qu'on mesure la distribution angulaire de la puissance hyperfréquence rayonnée par rapport à l'axe longitudinal du guide d'ondes dans le champ de rayonnement au point de sortie et l'on détermine, à partir de la distribution angulaire, le spectre des modes d'onde intéressants.

2. Procédé selon la revendication 1, caractérisé en ce qu'on détermine, à partir de chaque angle $\alpha$ entre la direction de rayonnement et l'axe longitudinal du guide d'ondes, la constante de propagation $\beta_h$ correspondant au nombre d'onde axial du mode respectivement mesuré dans le guide d'ondes, selon la relation:

$$\alpha = arc\ cos\ \frac{c \cdot \beta}{\omega \cdot n}$$

c étant la vitesse de la lumière, n l'indice de réfraction du milieu se trouvant à l'extérieur du guide d'ondes et $\omega$ la pulsation régnant dans le guide d'ondes.

3. Procédé selon la revendication 1 ou 2, caractérisé en ce que la puissance des modes est mesurée chaque fois dans le domaine des angles $\alpha$ de moins de 90° entre la direction de propagation respective et la direction de rayonnement.

4. Spectromètre pour mettre en œuvre le procédé selon la revendication 1, vomportant une structure de découplage de sortie (2) formée par des trous (5) répartis parallèlement à l'axe longitudinal du guide d'ondes ou une ou plusieurs fentes longitudinales dans la paroi d'un guide d'ondes hyperfréquence (1) surdimensioné, et un dispositif pour mesurer la puissance de sortie découplée, caractérisé en ce qu'il est placé à une certaine distance de la structure de découplage (2) au moins un antenne de réception (3) dont la position est réglable à divers angles $\alpha$ dans le champ de rayonnement sur la structure de découplage (2) par rapport à l'axe longitudinal du guide d'ondes, et en ce qu'à partir de la distribution angulaire, on peut déterminer le spectre des modes d'onde intéressants.

5. Spectromètre selon la revendication 4, caractérisé en ce que l'antenne de réception (3) peut pivoter autour d'un axe placé sur la structure de découplage (2) orthogonalement à l'axe longitudinal du guide d'ondes.

6. Spectromètre selon la revendication 5, caractérisé en ce que l'antenne de réception (3) est montée sur un bras (6) placé de façon à pouvoir sur le guide d'ondes (1).

7. Spectromètre selon l'une des revendications 4 à 6, caractérisé en ce qu'au moins une antenne de réception à sélectivité directionnelle (3) est placée dans le champ de proximité de la structure de découplage (2).

8. Spectromètre selon l'une des revendications 4 à 6, caractérisé en ce qu'au moins une antenne sélective ou non directionnellement sélective est placée dans le champ d'éloignement de la structure de découplage (2).

9. Spectromètre selon l'une revendications 4 à 8, caractérisé en ce que l'antenne (3) peut pivoter autour du centre d'une structure de découplage (2) en forme d'une rangée axiale de trous (5) dont l'intervalle intercentres mutuel est inférieur à la moitié de la longeur d'onde du mode du guide d'ondes de plus faible vitesse de phase, tandis que le diamètre des trous (5) diminue du centre de la structure de découplage (2) vers les deux extrémités selon une transparence aux hyperfréquences axiale sensiblement gaussienne.

10. Spectromètre selon l'une des revendications 4 à 9, caractérisé en ce que l'espace de rayonnement entre la structure de découplage (2) et l'antenne (3) est limité par des parois de blindage latérales en matière absorbante (4) parallèles au champ de rayonnement.

11. Spectromètre selon l'une des revendications 4 à 9, caractérisé en ce que les ondes sont guidées avant leur rayonnement entre des plaques métalliques ou dans une couche diélectrique.

12. Spectromètre selon l'une revendications 4 à 11, caractérisé en ce que les trous répartis axialement ou une fente longitudinale constituant la structure de découplage, pratiquée dans la paroi du guide d'ondes (1), sont remplis au moins partiellement d'un diélectrique.

13. Spectromètre selon l'une des revendications 4 à 12, caractérisé en ce qu'on prévoit deux antennes (3) déplaçables indépendamment l'une de l'autre.

14. Spectromètre selon l'une des revendications 4 à 13, caractérisé en ce que l'antenne (3) est déplaçable par un dispositif d'entraînement relié à un motuer qui est synchronisé avec le dispositif de mesure de puissance raccordé à l'antenne (3).

μ Wellen